**Europäisches Patentamt**

**European Patent Office**

**Office européen des brevets**

(19)

(11) Publication number : **0 562 826 A1**

## (12) EUROPEAN PATENT APPLICATION

(21) Application number : **93302207.1**

(22) Date of filing : **23.03.93**

(51) Int. Cl.$^5$ : **G03F 7/027, C08F 299/06**

(30) Priority : **27.03.92 US 858568**

(43) Date of publication of application :
**29.09.93 Bulletin 93/39**

(84) Designated Contracting States :
**DE FR GB IT**

(71) Applicant : **LOCTITE CORPORATION**
**Hartford Square North, 10 Columbus**
**Boulevard**
**Hartford, Connecticut 06106 (US)**

(72) Inventor : **Kadziela, Victor**
**190, Jerry Road**
**East Hartford, Connecticut 06108 (US)**
Inventor : **Sutkaitis, Donna M.**
**40 Renee Court**
**Cheshire, Connecticut 06410 (US)**
Inventor : **Rakas, Margaret A.**
**1203 Longmeadow Street**
**Longmeadow, Massachusetts 01106 (US)**

(74) Representative : **Everett, Susan Jane et al**
**Elkington and Fife Prospect House 8**
**Pembroke Road**
**Sevenoaks, Kent TN13 1XR (GB)**

(54) **Low viscosity self-toughening acrylate composition.**

(57) Compositions comprising :

A) A mixture of acrylate functional prepolymers in the total amount of between about 50% and 80% by weight of the composition, said prepolymer mixture comprising a first prepolymer which is a urethane diacrylate resin, suitably a polyether urethane diacrylate, having a viscosity of at least 500,000 mPa.sec at 25°C in an amount of between 10 and 40% by weight of the composition, and a second multi-acrylate prepolymer having a viscosity of between about 500 and 50,000 mPa.sec in an amount of at least 15 % by weight of the composition ;

B) A monoacrylate diluent monomer selected from the group consisting of isobornyl acrylate, β-carboxyethyl acrylate and mixtures thereof in an amount of at least 5 % by weight of the composition ; and,

C) An effective amount for cure initiation of a free radical initiator, the composition having a viscosity of less than 10,000 mPa.sec at 25°C, give unusual self-toughened cured properties. Such compositions, where the free radical initiator is a free radical photoinitiator, are particularly useful in rapid prototyping applications where the requirement for low viscosity and optical clarity of the liquid formulation has heretofore limited use of the formulations to ones giving undesirably brittle or soft properties.

EP 0 562 826 A1

## FIELD OF THE INVENTION

This invention relates to the field of curable acrylate prepolymer formulations and more particularly to such formulations used in the rapid prototyping industry.

## BACKGROUND OF THE INVENTION

The term "rapid prototyping," also referred to as "stereolithography" denotes a group of processes for the production of complex solid 3-dimensional objects by curing successive thin layers of photocurable liquid composition using a computer controlled laser to affect patterned photocuring of the liquid surface. Such techniques are described in detail in Murphy, et al, "Reduced Distortion in Optical Free Form Fabrications with UV Lasers", Radiation Curing, Feb-May 1989, pp. 3-7; Chemical Week, Sep 9, 1987, pp. 24-25; and in US patent 4,575,330; 4,801,447; 4,929,402; and 4,752,498.

Liquid formulations used in rapid prototyping applications must have a low viscosity, no more than 10,000 mPa. sec at 25°C, preferably 2,000 mPa. sec or less, have low shrinkage, and give good cure response to the UV laser. Heretofore it has been conventional to use formulations employing various acrylate ester functional prepolymers as the photocurable liquids for stereolithography because of the fast UV response time and lack of curing outside the irradiation boundary which acrylate esters provide. Such formulations have also uniformly employed N-vinyl pyrrolidone (NVP) as a reactive diluent because of its low vapor pressure, high solvent power, high reactivity and low vapor reactivity.

Conventional acrylate ester prepolymer based rapid prototyping formulations however suffer several major drawbacks. Among these are the fact that N-vinyl pyrrolidone has been identified as a potentially substantial risk material which has been banned in many industrial facilities worldwide. There therefore exists a need to identify satisfactory substitute formulations which do not employ NVP.

Another drawback is that the cured properties provided by the low viscosity acrylic ester prepolymer based formulations are very brittle so that the parts produced by the technique are highly susceptible to breakage when dropped or when used as a working part. While one manufacturer has recently introduced a product said to have "tough" cured properties, the properties thereof are more accurately described as soft and elastic during the stereolithographic curing process. The modulus builds up more slowly than the formulations of the invention disclosed herein, and is not suitable for producing working parts.

There therefore is a need for low viscosity rapid prototyping formulations which give cured hard and tough properties so that parts made therefrom are suitable for making working parts not susceptible to breakage. Unfortunately conventional techniques for toughening of curable liquid acrylic formulations are not available because of the limitations imposed on the uncured liquid by the rapid prototyping application. For instance, introducing tougheningly effective amounts of rubbery polymers increases the viscosity beyond acceptable limits. Using two-phase systems, whether it be a reinforcing filler or an incompatible second curable liquid reduces optical clarity of the formulation which is detrimental to UV response of the system.

## SUMMARY OF THE INVENTION

In seeking to prepare a formulation which is free of NVP, the inventors herein have discovered a low viscosity UV curable system which not only meets their objectives but also has unexpected self-toughening properties which give them substantial benefits over prior formulations designed for rapid prototyping.

Compositions within the invention are characterized as follows:

A) A mixture of acrylate functional prepolymers in the total amount of between about 50% and 80% by weight of the composition, said prepolymer mixture comprising a first prepolymer which is a urethane diacrylate resin having a viscosity of at least 500,000 mPa. sec at 25°C in an amount of between 10 and 40% by weight of the composition, and a second multi-acrylate prepolymer having a viscosity of between about 600 and 45, 000 mPa.sec at 25°C in an amount of at least 15 % by weight of the composition;

B) A monoacrylate diluent monomer selected from the group consisting of isobornyl acrylate, β-carboxyethyl acrylate and mixtures thereof in an amount of at least 5 % by weight of the composition; and,

C) An effective amount for cure initiation of a free radical initiator, the composition having a viscosity of less than 10,000 mPa.sec at 25°C.

In a narrower characterization of the invention the first prepolymer is a polyether urethane diacrylate, the second prepolymer is selected from the group consisting of polyester urethane acrylates, polyether urethane acrylates and epoxy acrylates, and the composition, when cured, has a tensile stress strain curve displaying a true yield point followed by a region of plastic deformation. Preferably the second prepolymer has a viscosity at 25°C of 6,000- 15,000 mPa.sec.

## DETAILED DESCRIPTION OF THE INVENTION

Compositions of the invention are free of NVP. Nevertheless, they give good response to UV lasers such as the 325nm He Cd laser utilized in the SLA™ system sold by 3D Systems, Inc., Valencia, CA. The viscosities of the formulations are all in the range usable for rapid prototyping applications, i.e., less than 10,000 mPa.sec, preferably less than 4000 mPa.sec, more preferably 500-2000 mPa.sec.

The preferred compositions also display low shrinkage in the 4-5% range, compared to typical values of 9-10% for acrylic formulations.

Whereas the conventional acrylic formulations used in UV processing are extremely brittle and do not yield, the formulations of the invention, when cured, give products which display true yield points (as defined in ASTM D638M, annex A1.10), without the necessity of adding reinforcing fillers or solid rubbery polymers which increase viscosity and opacity of the system.

The inventors have undertaken extensive investigations to characterize the reason for self-toughening behavior, to date, without any conclusive explanation. The Tg behavior of the cured formulations of the invention is not consistent with random copolymerization, but the inventors have also been unable to determine that the system is 2-phase. The formulations are optically clear, which is extremely unusual in 2-phase systems, and only a single Tg is observed. In formulations which utilize isobornyl acrylate as the diluent, moreover, the toughening behavior observed is particularly surprising since isobornyl acrylate gives a very hard glassy polymer having a glass transition temperature of 92°C.

The free radical initiator is preferably a photoinitiator or mixture of photoinitiators. Photoinitiators suitably employed in the preferred formulations include quinones, acetophenones, propiophenones, benzophenones, acyl phosphine oxides, thioacyl phosphines, titanocenes, etc. A more detailed list of suitable photoinitiators, including specific examples, is found in EP 0425440. The photoinitiator component in the inventive compositions may also suitably be a blend of photoinitiators which optimizes the curing response of the formulation to two or more UV-vis emission lines of a laser employed in a rapid prototyping device. Such blends of photoinitiators are described, for instance, in Sherman, A., "Balancing Formulation Storage Stability and Cure Behavior Through the Use of Photoinitiator Blends, "*Radcure '86 Conference Proceedings,* pp 4-13 - 4-25, (Sept 8-11, 1986), in US 4,017,652 and in EP 04225440. Suitable commercial photoinitiator blends include Darocure 4263 and Darocure 4265, sold by EM Industries. The photoinitiators are employed at levels of 0.1-10% typically 0.5-5% of the composition. For uses outside the field of rapid prototyping, thermal initiators such as peroxides, hydroperoxides, peresters, azonitriles, etc. may also be employed at conventional levels in the self-toughening formulations of the invention.

While the invention is characterized by the essential components set forth above, it will be appreciated that other components which do not materially change its essential novel characteristics, may be included in the compositions. For instance, a minor amount, suitably 1-15 %, of a methacrylate resin has been found useful to avoid formation of multiple unbonded fibers in a single line of the pattern made by the laser. A suitable such methacrylate resin is a 2000 MW ($M_n$) polyester urethane methacrylate (PEUMA).

Tri-, tetra- or higher functional acrylate or methacrylates may be employed to increase the crosslink density of the formulations. To maintain the desired yield point in the cured polymer, however, such material should ordinarily not exceed about 10 %, preferably 0.5-5% by weight of the composition.

Minor amounts, preferably less than 10%, of other mono-acrylate or mono-methacrylate diluent monomers may also be employed in the composition in addition to those required for component B of the formulation. Examples of such optional monomers include hydroxypropyl acrylate, hydroxypropyl methacrylate, hydroxyethyl acrylate and hydroxyethyl methacrylate.

Other additives conventionally employed in a curable acrylic formulation may also be employed, at conventional levels, provided, however, that for rapid prototyping formulations the requirements of low viscosity and adequate optical clarity must be maintained. Examples include antioxidants, light protectors, polymerization inhibitors, degassing agents, deaerating agents, plasticizers, extenders, fillers, and reinforcing agents, thixotropy-regulating agents, wetting and leveling agents, flameproofing agents, sensitizers, oxygen traps, antisettling agents, dyes, or pigments.

The rapid-prototyping formulations of the invention are preferably cured using weaving techniques. Such techniques, in which the laser tracing program is designed to produce interweaves between successive layers of the part being created are known to those skilled in the art. Details of one such increasing technique may be found in "SLA User Reference Manual, Sofwware Release Version 3.7.1.7, release 3.82, " © 3D Systems, 1990 and in Richter *et al*, "The Present State Of Accuracy In Stereolithography, " 3D Systems, Inc., Valencia CA (April, 1991).

The invention is illustrated by the following nonlimiting examples.

EXAMPLES

Formulations having viscosities and reactivities suitable for rapid prototyping applications were prepared as shown in Table I where quantities are given in parts by weight. Property measurements were made on cured films according to the following protocol and the results of the measurements are provided in Table II.

**Film Preparation**: All samples were prepared as films of 20 mil nominal thickness. Films were cured in a conveyerized UV oven (UV Fusion System). Each film received a total dose of 2535 mj/cm$^2$.

**Tensile Samples**: Samples from cured films were routed to widths of 0.25 inches using an ASTM D 882-83 routing jib. A modified version of this method was used: testing followed the specified width: thickness ratio as well as the crosshead speed guideline. Since the gage length was 1.97 inches (nonstandard length), a crosshead speed of 0.2 in/min was employed until 25% elongation had occurred. At that point, the crosshead speed was increased by a factor of 10, to 2.0 in/min. Samples were discarded if it was obvious that slippage had occurred. An Instron 4405 Universal Tester was used, and depending on the sample, either a 22.4 lb or a 50 lb load cell was used. It was standard practice to use the most sensitive load cell available; if samples fractured at, say 35 lbs, of course the 50 lb cell had to be used. Instron series IX software was used while testing to determine modulus, % strain at yield point, etc.

**Dynamic Mechanical Analysis**: A Rheometrics Dynamic Mechanical Analyzer was used to determine the Tg of all samples except Examples 1 -3 series, which were tested on a Rheometrics Solids Analyzer. A strain sweep, and in some cases two strain sweeps were performed on each sample to determine its linear elastic region [LER]. When that % strain range was known, 1 or two temperature sweeps were run within the noted strain limit. A frequency of 10 rad/sec was used for all samples unless otherwise noted.

| TABLE 1 - FORMULATIONS | | | | | | | | |
|---|---|---|---|---|---|---|---|---|
| Example | 1† | 2 | 3† | 4 | 5 | 6 | 7† | 8 |
| Photomer 6008 Polyether Urethane Acrylate | 9.1 | 54.1 | 65 | 10 | 16.0 | 16.0 | 13.5 | 13.5 |
| Radcure RSX 89462 Polyester Urethane Acrylate | 40 | 40 | 0 | 40 | 64 | 64 | 54.1 | 54.1 |
| Isobornyl Acrylate | 50 | 5 | 34.1 | 34.1 | 18.1 | 9.1 | 0 | 27 |
| PEUMA* | --- | --- | --- | 15 | 1.0 | 10.0 | 4.5 | 4.5 |
| Photoinitiator‡ | 0.9 | 0.9 | 0.9 | 0.9 | 0.9 | 0.9 | 0.9 | 0.9 |

| TABLE 1 - FORMULATIONS (CONTINUED) | | | | | | | | |
|---|---|---|---|---|---|---|---|---|
| Example | 9 | 10 | 11 | 12 | 13 | 14† | 15 | 16† |
| Photomer 6008 Polyether Urethane Acrylate | 33.6 | 33.5 | 30.0 | 33.6 | 30.0 | 13.5 | 13.5 | 13.5 |
| Radcure RSX 89462 Polyester Urethane Acrylate | --- | --- | --- | --- | --- | 54.1 | 54.1 | 54.1 |
| Photomer 6210 Polyether Urethane Acrylate | 15.0 | 15.0 | 15.0 | 15.0 | --- | --- | --- | --- |
| Ebecryl 830 Polyester Acrylate | --- | --- | --- | --- | 15.0 | --- | --- | --- |
| BASF Laromer® LR 8765 Polyester Acrylate | --- | --- | --- | 10 | --- | --- | --- | --- |
| Photomer 4127 Propoxylated Neopentyl Glycol Diacrylate | 10.0 | --- | --- | --- | --- | --- | --- | --- |
| Isobornyl Acrylate | 26.0 | 36.0 | 36.0 | 26.0 | 36.0 | --- | --- | --- |
| β-Carboxyethyl Acrylate | 14.5 | 14.5 | 14.5 | 14.5 | 14.5 | --- | 27.0 | --- |
| Dihydrocyclo-pentadienyl-oxyethyl Acrylate | --- | --- | --- | --- | --- | 27.0 | --- | --- |
| Phenoxyethyl Acrylate | --- | --- | --- | --- | --- | --- | --- | 27.0 |
| PEUMA* | --- | --- | --- | --- | --- | 4.5 | 4.5 | 4.5 |
| Photoinitiator‡ | 0.9 | 0.9 | 4.5 | 0.9 | 4.5 | 0.9 | 0.9 | 0.9 |

†Comparative examples.
* Urethane methacrylate capped 2,000 MW (M$_n$) polyester.
‡ In examples 11 and 13 the photoinitiator was 1-benzoyl cyclohexanol. In all others the photoinitiator was 2,4,6-trimethylbenzoyldiphenylphosphineoxide (TPO).

| TABLE 2 - PROPERTIES | | | | | | | | |
|---|---|---|---|---|---|---|---|---|
| Example | 1 | 2 | 3 | 4 | 5 | 6 | 7 | 8 |
| Tg | --- | --- | --- | 49.3 | 43.1 | 40 | 46 | 46 |
| Modulus, MPa (100psi) | 1515 (2197) | 1253 (1877) | 1696 (2460) | 881 (1278) | 680 (986) | 607 (880) | 401 (581) | 827 (1200) |
| Yield Stress, MPa (psi) | 41.22 (5978) | 34.94 (5068) | 49.06 (7115) | 27.18 (3942) | 19.20 (2784) | 17.69 (2565) | --- | 23.62 (3426) |
| Elongation at Yield, % | 4.97 | 5.34 | 5.32 | 5.02 | 7.60 | 8.28 | --- | 7.03 |
| Elongation at break, % | 5.55 | 17.03 | 5.51 | 24.70 | 46.80 | 52.40 | --- | 45.50 |
| $(\varepsilon_{br}-\varepsilon_y)/\varepsilon_{br}$ | 0.105 | 0.686 | 0.034 | 0.797 | 0.838 | 0.842 | --- | 0.845 |
| Plastic deformation | N | Y | N | Y | Y | Y | --- | Y |

| TABLE 2 - PROPERTIES (CONTINUED) | | | | | | | | |
|---|---|---|---|---|---|---|---|---|
| Example | 9 | 10 | 11 | 12 | 13 | 14 | 15 | 16 |
| Modulus, MPa (100psi) | 752 (1091) | 901 (1307) | 715 (1037) | 830 (1204) | 1596 (2315) | 168 (244) | 579 (840) | 14 (19.9) |
| Yield Stress, MPa (psi) | 16.48 (2390) | 18.71 (2713) | 16.24 (2356) | 17.29 (2507) | 41.64 (6039) | NA | 16.23 (2354) | NA |
| Elongation at Yield, % | 6.27 | 5.04 | 6.50 | 6.00 | 5.38 | NA | 7.40 | NA |
| Elongation at break, % | 36.25 | 29.73 | 67.1 | 26.52 | 9.76 | 55.7 | 92.3 | 59.5 |
| $(\varepsilon_{br}-\varepsilon_y)/\varepsilon_{br}$ | 0.83 | 0.83 | 0.9 | 0.77 | 0.45 | NA | 0.92 | NA |

The Photomer prepolymers utilized in the examples are trademarked products of Henkel Corp. Photomer 6008 is a aliphatic polyether urethane diacrylate oligomer resin having a viscosity at 25°C of 1,000,000-1,750,000 mPa.sec. Photomer 6210 is an aliphatic polyurethane diacrylate oligomer liquid having a viscosity of 13,000 mPa.sec at 25°C and a MW of about 1,400.

Radcure™ RSX-89462 is an aliphatic polyester urethane diacrylate prepolymer having a molecular weight of approximately 1,400 and a viscosity of 6,000 mPa.sec at 25°C. It's NMR profile indicates that there is an acyclic carbamate group adjacent to the acrylate end groups. The product is sold by Radcure Specialties Inc., Louisville KY.

BASF Laromer® LR 8765 is an epoxy acrylate oligomer (i.e., reaction product of an epoxy terminated oligomer and acrylic acid) sold by BASF which has a viscosity of approximately 600 mPa. sec at 25°C.

Ebecryl™ 830 is a polyester acrylate oligomer, sold by Radcure Specialties, Inc., Louisville KY, which has a molecular weight of approximately 1400 and a viscosity of approximately 45,000 at 25°C.

Referring to the tables, it can be seen that the products of Examples 1 and 3 displayed a yield point which was very close to the break strain so that there was essentially no plastic deformation before break. The value of $(\varepsilon_{br}-\varepsilon_y)/\varepsilon_{br}$ was well below the minimum required by the invention. This is a complex mixture phenomena as illustrated by the very different properties, within the scope of the invention, obtained with Examples 2, 4-7 and 8. The preferred formulation for rapid prototyping applications is Example 8.

Examples 14-16 illustrate the effect of changing monoacrylate monomers in the preferred formulation. The monoacrylate monomers used were commercially available low vapor pressure acrylic monomers. The formulation of Example 15, using β-CEA as a replacement for Isobornyl acrylate gave acceptable properties. However, the cured formulations of Examples 14 and 16, using other low vapor pressure acrylate monomers, gave unacceptable soft, rubbery cured materials.

In Examples 9-13, a mixture of isobornyl acrylate and β-CEA was successfully used to prepare formulations displaying desirable yield points followed by a region of plastic deformation. These Examples also demonstrate that the polyester urethane acrylate used in the other Examples can be replaced in whole or in part with other low viscosity diacrylate resins without loss of critical self-toughening properties. It was noted, however, that the product of Example 13 was near the approximately lower limit of practical benefit from a self-toughening standpoint, over typical acrylate-based rapid prototyping formulations. Thus, a reasonable lower limit for the value $(\varepsilon_{br}-\varepsilon_y)/\varepsilon_{br}$ is approximately 0.4. More preferably the value of $(\varepsilon_{br}-\varepsilon_y)/\varepsilon_{br}$ is at least 0.65.

## Claims

1. A low viscosity curable composition comprising:
   A) A mixture of acrylate functional prepolymers in the total amount of between about 50% and 80% by weight of the composition, the prepolymer mixture comprising a first prepolymer which is a urethane diacrylate resin having a viscosity of at least 500,000 mPa.sec at 25°C in an amount of between 10 and 40% by weight of the composition, and a second diacrylate prepolymer having a viscosity of between about 500 and 50,000 mPa.sec in an amount of at least 15% by weight of the composition;
   B) A monoacrylate diluent monomer selected from isobornyl acrylate, β-carboxyethyl acrylate or mixtures thereof in an amount of at least 5% by weight of the composition; and,
   C) A free radical initiator, the composition having a viscosity of less than 10,000 mPa.sec at 25°C.

2. A composition as claimed in claim 1 characterised in that the first prepolymer is a polyether urethane diacrylate.

3. A composition as claimed in claim 2 characterised in that the second prepolymer is a polyether urethane acrylate, a polyether urethane acrylate or an epoxy acrylate, and the composition, when cured, has a tensile stress strain curve displaying a true yield point followed by a region of plastic deformation.

4. A composition as claimed in any of claims 1 to 3 characterised in that the second prepolymer has a viscosity in the range of 6,000-15,000 mPa.sec at 25°C.

5. A composition as claimed in claim 3 or 4 characterised in that the second prepolymer is a diacrylate.

6. A composition as claimed in any of claims 3 to 5 characterised in that the yield stress of the cured polymer is less than about 42.1 MPa (6,100 psi).

7. A composition as claimed in claim 6 characterised in that the yield stress is less than about 37.9 MPa (5,500 psi).

8. A composition as claimed in any of claims 1 to 7 characterised in that the cured polymer has a stress strain curve satisfying the formula:
$$(\varepsilon_{br} - \varepsilon_y)/\varepsilon_{br} \geqq 0.4$$
where $\varepsilon_{br}$ is percent strain at break, and $\varepsilon_y$ is percent strain at yield.

9. A composition as claimed in claim 8 wherein
$$(\varepsilon_{br} - \varepsilon_y)/\varepsilon_{br} \geqq 0.65.$$

10. A composition as claimed in any of claims 1 to 9 characterised in that the free radical initiator is a photoinitiator.

**11.** A composition as claimed in claim 10 characterised in that the photoinitiator is a blend of photoinitiator compounds selected to optimize the response of the composition to at least two emission lines in the UV-vis wavelength range of a predetermined light source.

**12.** A composition as claimed in any of claims 1 to 11 characterised in that the composition viscosity is less than 4000 mPa.sec.

**13.** A method of rapid prototyping utilizing a computer-controlled laser to effect patterned photocuring at the surface of the body of a photocurable liquid in successive layers so as to build up a three-dimensional object, characterised in that the curable liquid is:

A) A mixture of acrylate functional prepolymers in the total amount of between about 50% and 80% by weight of the composition, the prepolymer mixture comprising a first prepolymer which is a urethane diacrylate resin having a viscosity of at least 500,000 mPa.sec at 25°C in an amount of between 10 and 40% by weight of the composition, and a second diacrylate prepolymer having a viscosity of between about 500 and 50,000 mPa.sec in an amount of at least 15% by weight of the composition;

B) A monoacrylate diluent monomer selected from isobornyl acrylate, β-carboxyethyl acrylate or mixtures thereof in an amount of at least 5% by weight of the composition; and,

C) A free radical initiator, the composition having a viscosity of less than 10,000 mPa.sec at 25°C.

European Patent
Office

**EUROPEAN SEARCH REPORT**

Application Number

EP 93 30 2207

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 141 330 (DESOTO) <br> * claims 1-4 * <br> --- | 1-5 | G03F7/027 <br> C08F299/06 |
| A | EP-A-0 409 419 (ACHESON INDUSTRIES) <br> * claims 1-9 * <br> --- | 1-5 | |
| A | EP-A-0 342 840 (M & T CHEMICALS) <br> ----- | 1-5 | |

TECHNICAL FIELDS
SEARCHED (Int. Cl.5 )

G03F
C08F

The present search report has been drawn up for all claims

| Place of search | Date of completion of the search | Examiner |
|---|---|---|
| THE HAGUE | 15 JULY 1993 | ANDRIOLLO G.R. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
....................................................................................
& : member of the same patent family, corresponding
document

EPO FORM 1503 03.82 (P0401)

9